# EUROPEAN PATENT SPECIFICATION

(11) **EP 3 081 062 B1**
(45) Date of publication and mention of the grant of the patent: **28.11.2018**
(21) Application number: 13805356.6
(22) Date of filing: 13.12.2013
(51) Int. Cl.: H05K 7/20, H05K 7/14

(54) **COOLING OF ELECTRONIC EQUIPMENT**
KÜHLUNG EINER ELEKTRONISCHEN VORRICHTUNG
REFROIDISSEMENT D'ÉQUIPEMENT ÉLECTRONIQUE

(43) Date of publication of application: 19.10.2016
(73) Proprietor: ABB Schweiz AG, 5400 Baden (CH)
(72) Inventor: ERIKSSON, Rolf, S-722 09 Västerås (SE)
(74) Representative: Lundqvist, Alida Maria Therése
(86) International application number: PCT/EP2013/076485
(87) International publication number: WO 2015/086087

(56) References cited:
- US-A1- 2007 034 360
- US-A1- 2010 097 767

## Description

### TECHNICAL FIELD

The invention relates to cooling of electronic equipment, and in particular to an electronics module comprising a thermally conductive panel, an arrangement comprising such an electronics module, and a method for providing such an electronics module.

### BACKGROUND

In general terms, input/output (I/O) modules are interface electronics where data is transferred to accomplish a function. I/O modules may be arranged to receive input data from sensors, transducers, controllers, etc. and send output data to other devices. In general terms, I/O modules comprise I/O logics (e.g., to provide data transfer between a central processing unit (CPU) and the I/O module), data lines (e.g., to provide data transfer between a system bus and the I/O module) and input/output interfaces (e.g., to control device operation). I/O modules may provide functions related to any of control and timing, processor communications, device communications, data buffering, and error detection. The I/O module may have data buffering capability to remove mismatch between speed of peripherals and CPU, and in built error detector mechanism for checking mechanical and communicational errors.

The I/O module comprises electronic equipment. The electronic equipment may comprise analog I/O modules, digital I/O modules, or any combination thereof. The digital I/O modules may have digital I/O circuits that interface to on/off sensors such as pushbuttons and limit switches and on/off actuators such as motor starters, pilot lights and actuators. The analog I/O modules may perform required analog to digital and digital to analog conversions to directly interface analog signals to data table values.

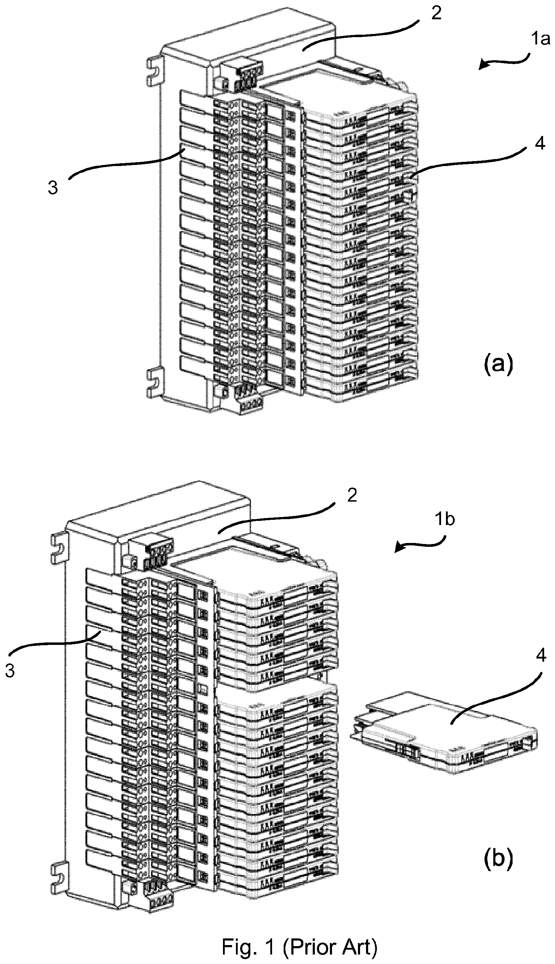

Consider the I/O module symbolized by the arrangement 1a in Fig 1a. The arrangement 1a consists mainly of a base plate 2, a number of field terminal blocks (FTBs) 3, and a corresponding number of electronics modules. The electronics modules 4 may be signal conditioning modules (SCMs). The FTBs 3 comprises screw clamps for connections of cables between remote field devices and the I/O module symbolized by the arrangement 1a. In the arrangement 1a of Fig 1a there are 16 FTBs 3 and 16 electronics modules 4. Each electronics module 4 comprises a printed circuit board (PCB) assembly comprising electronic equipment for signal conditioning. The base plate 2 is a carrier of the electronics modules 4 and the FTBs 3 and likewise acts as a holder device for the I/O module symbolized by the arrangement 1a.

One requirement for an I/O module may be to have a compact design, for example in order to allow many electronics modules in a cabinet. One requirement for an I/O module may be to have high reliability and long life time. One requirement for an I/O module may be to have resistance to high ambient temperature. It may be a challenging to combine these requirements since the electronics equipment in the electronics modules dissipate power which generates heat. More particularly, as noted above, the electronics modules contain PCBs with electronic components. The electronic components produce an amount of heat that has to be kept as low as possible to reach high reliability and long life time for the components on the PCB, although the ambient temperature is high.

US 2010/097767 A1 relates to a machine for passively removing heat generated by an electronic circuit board. Heat generated by the electronic circuit board is passively removed by means of high thermal conductivity moldable pads applied to both sides of the electronic circuit board to form a conductive pathway to transport heat away from electronic circuits and components.

US 2007/0034360 A1 discloses an assembly for high performance cooling of electronics that includes a container for heat transfer liquid in which complex electronic assemblies are immersed. A thermally conductive plate is made part of the liquid filled container assembly such that a portion of the plate is in contact with the liquid an a portion of the plate protrudes from or forms part of the exterior of the container.

Hence there is a need for cooling of electronic equipment.

### SUMMARY

An object of embodiments herein is to provide mechanisms for cooling of electronic equipment.

According to a first aspect there is presented an electronics module. The electronics module comprises a circuit board. The circuit board comprises electronic equipment. The electronics module comprises a housing. The housing encloses the circuit board. The electronics module comprises a thermally conductive panel. The thermally conductive panel at least partly covers at least two opposite side surfaces of the housing.

Advantageously, the electronics module provides cooling of electronic equipment.

Advantageously, the electronics module is allowed to be of compact design and thus applicable when the space is limited.

Advantageously, the electronics module enables life time of the electronic equipment to be prolonged.

For example, the electronics module efficiently reduces the temperature caused by heat generating electronic equipment.

Advantageously, the electronics module is cost effective.

According to a second aspect there is presented an arrangement. The arrangement comprises a base plate. The arrangement comprises at least two field terminal blocks. The at least two field terminal blocks are adjacently stacked on the base plate. Each one of the at least two field terminal blocks comprises an electronics module according to the first aspect.

According to a third aspect there is presented a method for providing an electronics module. The method comprises providing a circuit board. The circuit board comprises electronic equipment. The method comprises enclosing the circuit board in a housing. The method comprises slipping a thermally conductive panel over the housing. The thermally conductive panel at least partly covers at least two opposite side surfaces of the housing. An electronics module is thereby provided.

It is to be noted that any feature of the first, second and third aspects may be applied to any other aspect, wherever appropriate. Likewise, any advantage of the first aspect may equally apply to the second, and/or third aspect, respectively, and vice versa. Other objectives, features and advantages of the enclosed embodiments will be apparent from the following detailed disclosure, from the attached dependent claims as well as from the drawings. Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Figs 1a, and 1b schematically illustrate arrangements according to prior art;
Fig 2 schematically illustrates an electronics module according to prior art;
Fig 3 schematically illustrates an electronics module according to an embodiment;
Figs 4a, 4b, 4c, and 4d schematically illustrate thermally conductive panels according to embodiments;
Fig 5 schematically illustrates an arrangement according to an embodiment;
Fig 6 shows simulation results of power dissipation as a function of temperature rise for different electronics modules; and
Fig 7 is a flowchart of methods according to embodiments.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

Figs 1a, and 1b schematically illustrate known arrangements 1a, 1b for input/output (I/O) systems. The arrangements 1a, 1b comprise a base plate 2. A plurality of field terminal blocks (FTBs) 3 are stacked adjacently on the base plate 2. Each one of the FTBs comprises an electronics module 4. In the arrangement 1b of Fig 1b one such electronics module 4 has been removed from the stack of FTBs.

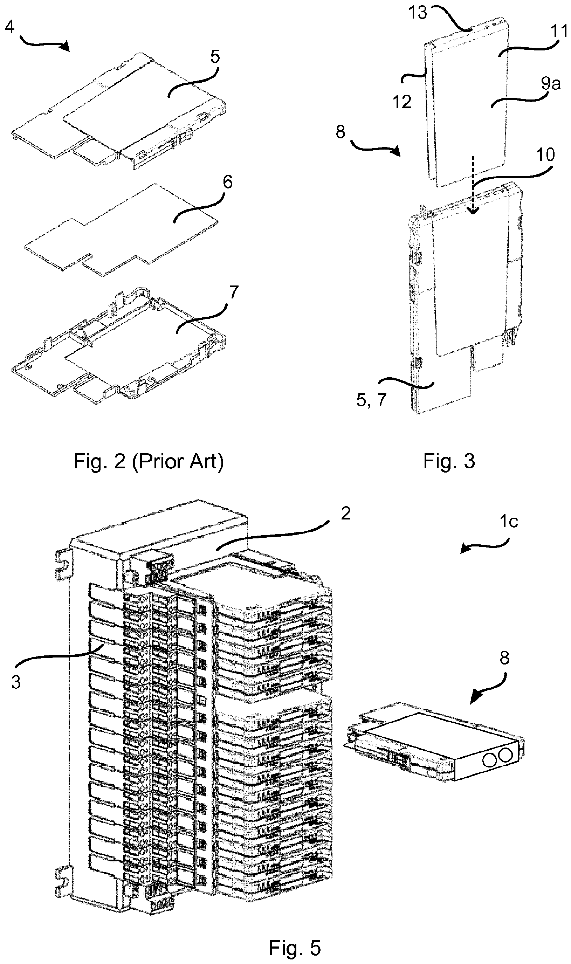

Fig 2 schematically illustrates a disassembled, known, electronics module 4. The electronics module 4 comprises a circuit board 6. The circuit board 6 comprises electronic equipment. The circuit board 6 is enclosed by a housing 5, 7 having a first part (such as an upper half) 5 and a second part (such as a bottom part) 7. The housing may be made of plastic.

The electronic equipment may be provided as a printed circuit board (PCB). The electronic equipment may be arranged to provide signal conditioning. The electronics module 4 may thus be a signal conditioning module. In general terms, signal conditioning involves manipulating an analog signal in such a way that it meets requirements of a next processing stage. One common use is in analog-to-digital converters (ADCs). In control engineering applications, it is common to have a sensing stage (which comprises at least one sensor) producing a sensor signal, a signal conditioning stage (where amplification of the sensor signal may be performed) and a processing stage (commonly performed out by an ADC and a micro-controller). Operational amplifiers (Op-Amps) are commonly employed to carry out the amplification of the sensor signal in the signal conditioning stage. Signal conditioning may include amplification, filtering, converting, range matching, isolation and any other processes required to make the sensor signal suitable for processing after conditioning. Types of devices that use signal conditioning include, but are not limited to, signal filters, instrument amplifiers, sample-and-hold amplifiers, isolation amplifiers, signal isolators, multiplexers, bridge conditioners, analog-to-digital converters, digital-to-analog converters, frequency converters or translators, voltage converters or inverters, frequency-to-voltage converters, voltage-to-frequency converters, current-to-voltage converters, current loop converters, and charge converters.

The electronic equipment produces an amount of heat that has to be kept as low as possible to reach high reliability and long life time for the components on the circuit board 6 although the ambient temperature is high. During operation of the electronics module 4 heat is thus generated by the electronic equipment of the circuit board 6.

One object of embodiments presented herein is to provide improved mechanism for cooling of electronic equipment provided in the electronics module. The present invention addresses this object by providing the electronics module with a thermally conductive panel. According to one particular aspect there is proposed to attach individual thermally conductive panels to cover the sides and the front of each electronics module.

Fig 3 schematically illustrates an electronics module 8 according to an embodiment. The electronics module 8 comprises a circuit board 6 (as illustrated in Fig 2; not seen in Fig 3). The circuit board 6 comprises electronic equipment. The electronics module 8 further comprises a housing 5, 7. The housing may have a first part 5 and a second part 7. Together the first part 5 of the housing and the second part 7 of the housing enclose the circuit board 6, and hence also enclose the electronic equipment. When in use the electronic equipment of the circuit board 6 generates heat. The electronics module 8 therefore comprises a thermally conductive panel 9a. The thermally conductive panel 9a is provided to at least partly cover at least two opposite side surfaces of the housing 5, 7. The thermally conductive panel 9a thereby acts as a cooling panel for the electronics module 8. The thermally conductive panel 9a may be slipped over the housing 5, 7, as indicated by the dashed arrow 10 in Fig 3.

In general terms, the thermally conductive panel 9a may be provided in different shapes, forms, and sizes, whilst still being arranged to at least partly cover at least two opposite side surfaces of the housing 5, 7.

For example, the thermally conductive panel may be designed as a U-shaped cover which may be threaded over the housing 5, 7 from the front side of the housing 5, 7 (i.e., the side of the housing 5, 7 facing away from the FTB 3 when coupled thereto). The top part of Fig 3 illustrates such a thermally conductive panel 9a. Hence, according to an embodiment the thermally conductive panel 9a comprises two parallel long side walls 11, 12 and one short side wall 13. The two parallel long side walls 11, 12 extend transversely from the short side wall 13. Each one of the two parallel long side walls 11, 12 at least partly covers a respective one of the at least two opposite side surfaces of the housing 5, 7.

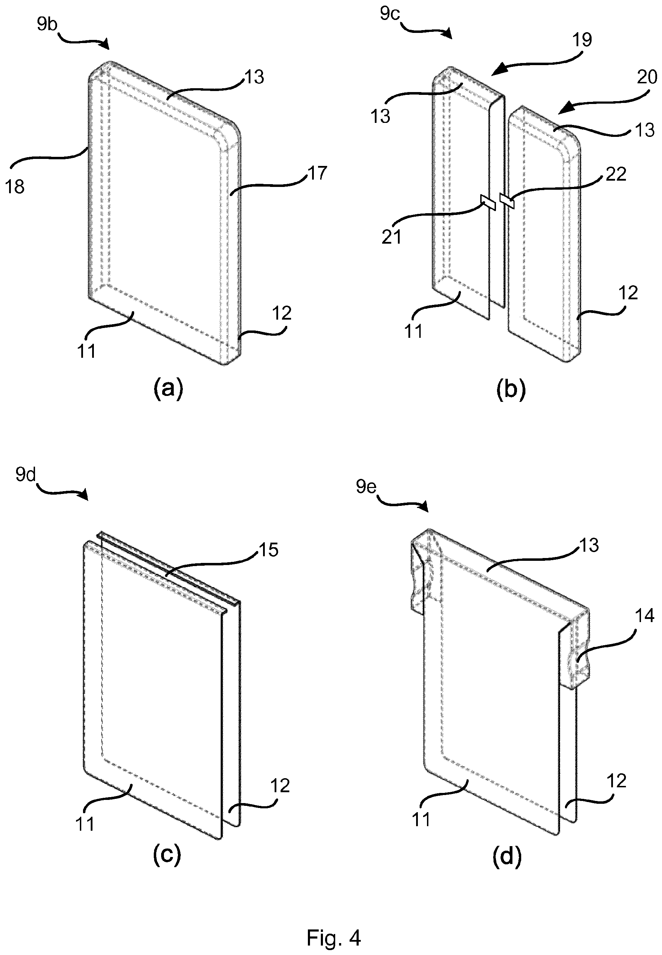

Figs 4a, 4b, 4c, and 4d schematically illustrate thermally conductive panels 9b, 9c, 9d, and 9e, respectively, according to further embodiments.

For example, the thermally conductive panel may be provided with side walls, top walls, gable wall, and an open bottom part. The thermally conductive panel may then be slipped on to the housing 5, 7 from the front side of the housing 5, 7. Fig 4a illustrates such a thermally conductive panel 9b. Hence, according to an embodiment the thermally conductive panel 9a comprises two parallel long side walls 11, 12, one short side wall 13, and two parallel gable walls 17, 18. The two parallel long side walls 11, 12 extend transversely from the short side wall 13. The two parallel gable walls 17, 18 extend from the short side wall 13 between the two parallel long side walls 11, 12.

For example, the thermally conductive panel may be provided as two covers slipped on to the housing 5, 7 from the gables of the housing 5, 7. Each cover may be provided with a short side wall and a gable wall. Fig 4a illustrates such a thermally conductive panel 9b. Thus, in relation to the thermally conductive panel 9b of Fig 4a the thermally conductive panel 9c of Fig 4b may be regarded as divided into two parts 19, 20. Hence, according to an embodiment the thermally conductive panel 9c is divided into two parts 19, 20 along a cut through the short side wall 13 and the two parallel long side walls 11, 12. The two parts 19, 20 may be fastened to each other. Hence, the thermally conductive panel 9c may be provided with engaging means 21, 22. Particularly, according to an embodiment each one of the two parts 19, 20 comprises engaging means 21, 22 for engaging with the other of the two parts 19, 20. Alternatively the two parts 19, 20 are provided to fit tightly over the housing 5, 7. The tight fit may thus prevent the two parts 19, 20 from unintentionally slipping off the housing 5, 7.

For example, the thermally conductive panel may be provided as two L-formed side plates which are attached to the sides of the housing 5, 7. Fig 4c illustrates such a thermally conductive panel 9d. Hence, according to an embodiment the thermally conductive panel 9d comprises two parallel L-shaped walls 11, 12. Each one of the two parallel L-shaped walls 11, 12 at least partly covers a respective one of the at least two opposite side surfaces of the housing 5, 7 and thereby at least partly covers a short side of the housing 5, 7. The two parallel L-shaped walls 11, 12 may allow a gap 15 to be formed between the respective short sides of the two parallel L-shaped walls 11, 12 when attached to the housing 5, 7.

For example, the thermally conductive panel may be provided with handles. Fig 4d illustrates such a thermally conductive panel 9e. For example, the thermally conductive panel 9e may be of a U-shaped cover comprising side parts 11, 12 and where the bottom of the U (i.e., the short side wall 13) is formed as handles usable for retracting the electronics module 8 from the FTB 3. Hence, according to an embodiment the thermally conductive panel 9e comprises gripping means 14 for engaging with the housing 5, 7. The gripping means 14 may be provided on at least one gable side of the thermally conductive panel 9e. Although the thermally conductive panel 9e has a U-shape, any of the thermally conductive panels 9a, 9b, 9c, and 9d may comprise gripping means 14.

Further features of the above disclosed electronics module 8, and particularly the above disclosed thermally conductive panel 9a, 9b, 9c, 9d, 9e will now be disclosed.

The thermally conductive panel 9a, 9b, 9c, 9d, 9e may be made of a metal. For example, the thermally conductive panel 9a, 9b, 9c, 9d, 9e may be made of a metal which has good thermal conductivity such as aluminium or copper. Thus, according to one embodiment the thermally conductive panel 9a, 9b, 9c, 9d, 9e is made from metal.

The thermal properties of the thermally conductive panel 9a, 9b, 9c, 9d, 9e may be improved by providing a surface treatment of the thermally conductive panel 9a, 9b, 9c, 9d, 9e. For example, a black anodic oxide film may be provided on the thermally conductive panel 9a, 9b, 9c, 9d, 9e. Thus, according to an embodiment the thermally conductive panel 9a, 9b, 9c, 9d, 9e on its surfaces facing away from the housing 5, 7 is provided with a black anodic oxide film.

The thermally conductive panel 9a, 9b, 9c, 9d, 9e may be of metal as well as being provided with a black anodic oxide film.

The electronics module 8 may be a signal conditioning module (SCM).

Fig 5 schematically illustrates an arrangement 1c according to an embodiment. The arrangement 1c may be an I/O module. The arrangement 1c comprises a base plate 2. The arrangement 1c further comprises at least two field terminal blocks 3. The at least two field terminal blocks 3 are stacked adjacently on the base plate 2. Each one of the at least two field terminal blocks 3 comprises an electronics module 8 comprises a thermally conductive panel 9a, 9b, 9c, 9d, 9e as disclosed herein. The herein disclosed thermally conductive panel 9a, 9b, 9c, 9d, 9e may thus be suitable for providing heat distribution and cooling when a group of electronics modules 8 are mounted close together, such as on adjacently stacked terminal blocks 3.

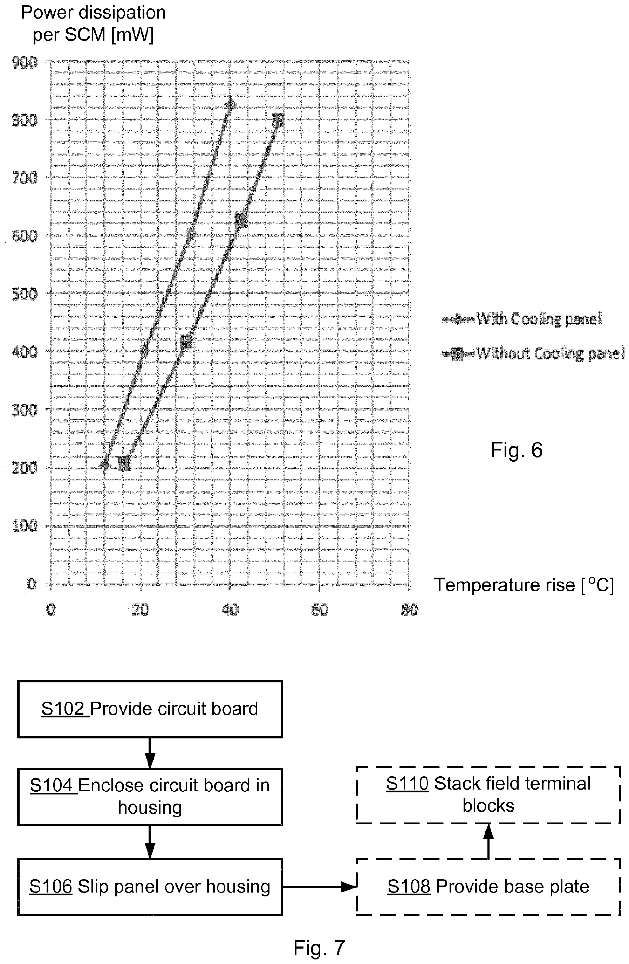

Fig 7 is a flowchart of methods for providing an electronics module 8 according to embodiments. The method comprises, in a step S102, providing a circuit board 6. The circuit board 6 comprises electronic equipment. The method comprises, in a step S104, enclosing the circuit board 6 in a housing 5, 7. The method comprises, in a step S106, slipping a thermally conductive panel 9a, 9b, 9c, 9d, 9e over the housing and thereby provide the electronics module 8. The thermally conductive panel 9a, 9b, 9c, 9d, 9e at least partly covers at least two opposite side surfaces of the housing 5, 7.

According to an embodiment the method further comprises, in an optional step S108, providing a base plate 2. According to an embodiment the method further comprises, in an optional step S110, adjacently stacking at least two field terminal blocks 3 on the base plate 2. Each one of the at least two field terminal blocks 3 comprises an electronics module 9a, 9b, 9c, 9d, 9e as provided in steps S102, S104, and S106.

Measurements indicate that the disclosed thermally conductive panel 9a yields significant reduction of the temperature inside the electronics module 8. Measurements were performed with 16 electronics modules 8 placed vertically in a stack of FTBs 3 on a base plate 2 as shown in Fig 5. All of the electronics modules 8 were first provided with individual thermally conductive panel 9a. The thermally conductive panel 9a was made of a black anodized aluminium plate with a thickness of 0.5 mm. The measurements were repeated for electronics modules 4 without any thermally conductive panel 9a. During the measurements temperature sensors were placed inside all of the electronics modules 4, 8. The temperature sensors were placed close to heat-producing electronic equipment of the circuit boards 6. Temperature sensors were also place outside the stack of the electronics modules 4, 8 in order for the ambient temperature to be measured.

Before the measurements started all of the electronics modules 4, 8 were powered equally until all temperatures were stable. Measurements were made with thermally conductive panels 9a respectively without thermally conductive panels 9a and with power dissipations from about 200 mW to about 800 mW in each electronics module 4, 8.

Measurements made without any thermally conductive panels 9a and about 800 mW per electronics module 4 gave a difference of about 51 °C between ambient temperature and the temperature inside the warmest electronics module 4 in the stack.

Measurements made with thermally conductive panels 9a and about 800 mW per electronics module 8 gave a difference of about 40 °C between ambient temperature and the temperature inside the warmest electronics module 8 in the stack.

Hence, the disclosed thermally conductive panel 9a reduces the temperature of about 11 °C with 800 mW power dissipation. Results of the measurements are provided in Fig 6 which compares the power dissipation per electronics module 4, 8 as function of temperature rise for electronics modules 8 with thermally conductive panels 9a and electronics modules 4 without thermally conductive panels 9a, respectively.

The invention has mainly been described above with reference to a few embodiments. However, as is readily appreciated by a person skilled in the art, other embodiments than the ones disclosed above are equally possible within the scope of the invention, as defined by the appended patent claims. For example, although the herein disclosed electronics module 8 has been described in the context of an I/O module, the electronics module 8 may be used for other types of electronic modules than I/O modules. In general terms, the herein disclosed electronics module 8 is suitable for all types of tightly packed devices containing electronics for different purposes. Thermally conductive panels 9a, 9b, 9c, 9d, ge are mounted on each of the devices and lower the temperature inside the devices for increased life time of the electronics and improved availability of the electronics. The herein disclosed thermally conductive panels 9a, 9b, 9c, 9d, 9e thus enable a passive and cost effective cooling facility.

## Claims

1. An electronics module (8) for coupling to a field terminal block, the electronics module comprising:
a circuit board (6) comprising electronic equipment;
a housing (5, 7) enclosing the circuit board; and
a thermally conductive panel (9a, 9b, 9c, 9d, 9e), the thermally conductive panel at least partly covering at least two opposite side surfaces of the housing **characterized in that** the thermally conductive panel is a U-shaped cover threaded over the housing from the front side of the housing (5,7), wherein the front side of the housing is the side of the housing facing away from the field terminal block when coupled thereto.

2. The electronics module according to claim 1, wherein the thermally conductive panel comprises two parallel long side walls (11, 12) and one short side wall (13), wherein the two parallel long side walls extend transversely from the short side wall, and wherein each one of the two parallel long side walls at least partly covers a respective one of the at least two opposite side surfaces of the housing.

3. The electronics module according to any one of the preceding claims, wherein the thermally conductive panel comprises gripping means (14) for engaging with the housing.

4. The electronics module according to claim 3, wherein the gripping means is provided on at least one gable side of the thermally conductive panel.

5. The electronics module according to claim 1, wherein the thermally conductive panel is made from metal.

6. The electronics module according to any one of the preceding claims, wherein the thermally conductive panel is provided with a black anodic oxide film on its surfaces facing away from the housing.

7. The electronics module according to any one of the preceding claims, wherein the housing is made from plastic.

8. An arrangement (1c) comprising:
a base plate (2);
at least two field terminal blocks (3), wherein the at least two field terminal blocks are adjacently stacked on the base plate; and
wherein each one of the at least two field terminal blocks comprises an electronics module (8) according to claim 1.

9. A method for providing an electronics module (8) for coupling to a field terminal block, the method, comprising:
providing (S102) a circuit board (6) comprising electronic equipment;
enclosing (S104) the circuit board in a housing (5, 7); and
slipping (S106) a thermally conductive panel (9a, 9b, 9c, 9d, 9e) over the housing, the thermally conductive panel at least partly covering at least two opposite side surfaces of the housing, thereby providing the electronics module,
wherein the thermally conductive panel is a U-shaped cover threaded over the housing from a front side of the housing, and the front side of the housing is a side of the housing facing away from the field terminal block when the electronics module is coupled to the field terminal block.

10. The method according to claim 9, further comprising:
providing (S108) a base plate (2); and
adjacently (S110) stacking at least two field terminal blocks (3) on the base plate;
wherein each one of the at least two field terminal blocks comprises an electronics module provided according to claim 9.

## Patentansprüche

1. Elektronikmodul (8) zum Koppeln an eine Feldklemmleiste, wobei das Elektronikmodul umfasst:
eine Schaltplatine (6), die Elektronikgerätschaften umfasst;
ein Gehäuse (5, 7), welches die Schaltplatine umschließt; und
eine wärmeleitende Platte (9a, 9b, 9c, 9d, 9e), wobei die wärmeleitende Platte mindestens zwei gegenüber liegende Seitenflächen des Gehäuses mindestens teilweise bedeckt, **dadurch gekennzeichnet, dass** die wärmeleitende Platte eine U-förmige Abdeckung ist, die von der Vorderseite des Gehäuses (5, 7) über das Gehäuse gefädelt wird, wobei die Vorderseite des Gehäuses die Seite des Gehäuses ist, die von der Feldklemmleiste weg weist, wenn sie daran gekoppelt wird.

2. Elektronikmodul nach Anspruch 1, wobei die wärmeleitende Platte zwei parallele lange Seitenwände (11, 12) und eine kurze Seitenwand (13) umfasst, wobei die beiden parallelen langen Seitenwände sich quer von der kurzen Seitenwand erstrecken, und wobei jede von den beiden parallelen langen Seitenwänden mindestens teilweise jeweils eine der mindestens zwei gegenüber liegenden Seitenflächen des Gehäuses bedeckt.

3. Elektronikmodul nach einem der vorhergehenden Ansprüche, wobei die wärmeleitende Platte Greifmittel (14) zum Eingriff mit dem Gehäuse umfasst.

4. Elektronikmodul nach Anspruch 3, wobei das Greifmittel an mindestens einer Giebelseite der wärmeleitenden Platte bereitgestellt wird.

5. Elektronikmodul nach Anspruch 1, wobei die wärmeleitende Platte aus Metall gefertigt ist.

6. Elektronikmodul nach einem der vorhergehenden Ansprüche, wobei die wärmeleitende Platte mit einem schwarzen anodischen Oxidfilm auf ihren Flächen ausgestattet ist, die von dem Gehäuse weg weisen.

7. Elektronikmodul nach einem der vorhergehenden Ansprüche, wobei das Gehäuse aus Kunststoff gefertigt ist.

8. Anordnung (1c), umfassend:
eine Basisplatte (2);
mindestens zwei Feldklemmleisten (3), wobei die mindestens zwei Feldklemmleisten benachbart auf der Basisplatte gestapelt sind; und
wobei jede der mindestens zwei Feldklemmleisten ein Elektronikmodul (8) nach Anspruch 1 umfasst.

9. Verfahren zum Bereitstellen eines Elektronikmoduls (8) zum Koppeln an eine Feldklemmleiste, wobei das Verfahren umfasst:
Bereitstellen (S102) einer Schaltplatine (6), die Elektronikgerätschaften umfasst;
Einschließen (S104) der Schaltplatine in ein Gehäuse (5, 7); und
Gleitenlassen (S106) einer wärmeleitenden Platte (9a, 9b, 9c, 9d, 9e) über das Gehäuse, wobei die wärmeleitende Platte mindestens zwei gegenüber liegende Seitenflächen des Gehäuses mindestens teilweise bedeckt, wodurch das Elektronikmodul bereitgestellt wird,
wobei die wärmeleitende Platte eine U-förmige Abdeckung ist, die von einer Vorderseite des Gehäuses über das Gehäuse gefädelt wird, und wobei die Vorderseite des Gehäuses eine Seite des Gehäuses ist, die von der Feldklemmleiste weg weist, wenn das Elektronikmodul an die Feldklemmleiste gekoppelt ist.

10. Verfahren nach Anspruch 9, des Weiteren umfassend:
Bereitstellen (S108) einer Basisplatte (2); und
Stapeln von mindestens zwei Feldklemmleisten (3) nebeneinander (S110) auf der Basisplatte;
wobei jede der mindestens zwei Feldklemmleisten ein Elektronikmodul umfasst, das nach Anspruch 9 bereitgestellt wird.

## Revendications

1. Module électronique (8) pour être couplé à une plaque à bornes de secteur, le module électronique comprenant :
une carte de circuit imprimé (6) comprenant un équipement électronique ;
un boîtier (5, 7) renfermant la carte de circuit imprimé ; et
un panneau thermoconducteur (9a, 9b, 9c, 9d, 9e), le panneau thermoconducteur recouvrant au moins partiellement au moins deux surfaces latérales opposées du boîtier, **caractérisé en ce que** le panneau thermoconducteur est un couvercle en forme de U monté sur le boîtier depuis le côté avant du boîtier (5, 7), dans lequel le côté avant du boîtier est le côté du boîtier qui fait face à l'opposé de la plaque à bornes de secteur lorsqu'il est couplé à cette dernière.

2. Module électronique selon la revendication 1, dans lequel le panneau thermoconducteur comprend deux longues parois latérales parallèles (11, 12) et une courte paroi latérale (13), dans lequel les deux longues parois latérales parallèles s'étendent de manière transversale depuis la courte paroi latérale et dans lequel chacune des deux longues parois latérales parallèles recouvre au moins partiellement une surface latérale opposée respective des deux, ou plus, surfaces latérales opposées du boîtier.

3. Module électronique selon l'une quelconque des revendications précédentes, dans lequel le panneau thermoconducteur comprend un moyen de préhension (14) pour venir en prise avec le boîtier.

4. Module électronique selon la revendication 3, dans lequel le moyen de préhension est disposé sur au moins un côté galbé du panneau thermoconducteur.

5. Module électronique selon la revendication 1, dans lequel le panneau thermoconducteur est réalisé en métal.

6. Module électronique selon l'une quelconque des revendications précédentes, dans lequel le panneau thermoconducteur est pourvu d'un film d'oxyde anodique noir sur ses surfaces faisant face à l'opposé du boîtier.

7. Module électronique selon l'une quelconque des revendications précédentes, dans lequel le boîtier est réalisé en matière plastique.

8. Agencement (1c) comprenant :
une plaque de base (2) ;
au moins deux plaques à bornes de secteur (3), dans lequel les deux, ou plus, plaques à bornes de secteur sont empilées de manière adjacente sur la plaque de base ; et
dans lequel chaque plaque à bornes de secteur des deux, ou plus, plaques à bornes de secteur comprend un module électronique (8) selon la revendication 1.

9. Procédé pour fournir un module électronique (8) pour être couplé à une plaque à bornes de secteur, le procédé consistant :
à fournir (S102) une carte de circuit imprimé (6) comprenant un équipement électronique ;
à enfermer (S104) la carte de circuit imprimé dans un boîtier (5, 7) ; et
à faire glisser (S106) un panneau thermoconducteur (9a, 9b, 9c, 9d, 9e) sur le boîtier, le panneau thermoconducteur recouvrant au moins partiellement au moins deux surfaces latérales opposées du boîtier, ce qui permet de fournir le module électronique,
dans lequel le panneau thermoconducteur est un couvercle en forme de U monté sur le boîtier depuis un côté avant du boîtier, et le côté avant du boîtier est un côté du boîtier qui fait face à l'opposé de la plaque à bornes de secteur lorsque le module électronique est couplé à la plaque à bornes de secteur.

10. Procédé selon la revendication 9, consistant en outre :
à fournir (S108) une plaque de base (2) ; et
à empiler de manière adjacente (S110) au moins deux plaques à bornes de secteur (3) sur la plaque de base ;
dans lequel chaque plaque à bornes de secteur des deux, ou plus, plaques à bornes de secteur comprend un module électronique fourni selon la revendication 9.
